# FASCICULE DE BREVET EUROPEEN

(11) **EP 2 586 063 B1**
(45) Date de publication et mention de la délivrance du brevet: **30.04.2014**
(21) Numéro de dépôt: 11738048.5
(22) Date de dépôt: 22.06.2011
(51) Int. Cl.: H01L 31/0224, H01L 31/18, H01L 31/0236

(54) **SUBSTRAT COMPRENANT UNE COUCHE D'OXYDE TRANSPARENT CONDUCTEUR ET SON PROCÉDÉ DE FABRICATION**
DURCHSICHTIGE LEITFÄHIGE OXIDSCHICHT ENTHALDENDES SUBSTRAT UND HERSTELLUNGSVERFAHREN
SUBSTRATE COMPRISING A TRANSPARENT CONDUCTIVE OXIDE LAYER AND MANUFACTURING PROCESS

(30) Priorité: 23.06.2010 FR 1002626
(43) Date de publication de la demande: 01.05.2013
(73) Titulaire: Commissariat à l'Énergie Atomique et aux Énergies Alternatives, 75015 Paris (FR)
(72) Inventeur: PEREIRA, Alexandre, F-38950 Saint Martin le Vinoux (FR); DUCROS, Cédric, F-38690 Bevenais (FR); TEBBY, Zoé, F-37350 Le Grand Pressigny (FR)
(74) Mandataire: Noel, Chantal Odile
(86) Numéro de dépôt international: PCT/IB2011/052738
(87) Numéro de publication internationale: WO 2011/161632

(56) Documents cités:
- EP-A1- 1 653 519
- WO-A1-00/28603
- WO-A1-2006/046397

## Description

L'invention concerne un substrat comprenant au moins une couche diffusante en un oxyde transparent conducteur (TCO), ainsi qu'un procédé de fabrication d'un tel substrat.

Elle concerne également une cellule solaire comprenant un tel substrat.

Le développement de dépôt d'oxydes transparents conducteurs (TCO) présentant des performances optiques et électriques optimales, c'est-à-dire typiquement une transmission supérieure à 90% dans la gamme des longueurs d'onde comprise entre 350 et 1100 nm et une résistivité inférieure à 5x10⁻⁴ Ω.cm, est un sujet d'étude majeur dans l'évolution des performances des cellules solaires en couches minces. Ces cellules solaires sont des cellules à base de silicium hydrogéné amorphe (a-Si:H), des cellules tandem, des cellules à base d'une couche d'absorbeur en Cu(In,Ga)Se₂ (CIGS) etc...

Dans ces cellules solaires, la texturation de surface des TCO est utilisée pour améliorer la diffusion des photons vers le matériau actif de la cellule solaire (piégeage optique), et ainsi augmenter les rendements de conversion photo-électrique.

La réponse optique d'une couche d'oxyde transparent conducteur texturé est, en général, traduite par la "Haze Value", c'est-à-dire le facteur de diffusion de la lumière.

Cette grandeur représente le rapport de la lumière diffusée transmise sur la lumière totale transmise,

Afin d'améliorer cette diffusion des photons vers le matériau actif de la cellule solaire et ainsi augmenter les rendements de conversion photo-électrique, il est connu de « texturer » la surface de la couche d'oxyde transparent par laquelle la lumière incidente pénètre dans la cellule solaire. Cette « texturation » correspond à la création d'une rugosité, c'est-à-dire d'une série de creux et de reliefs à la surface de la couche de TCO.

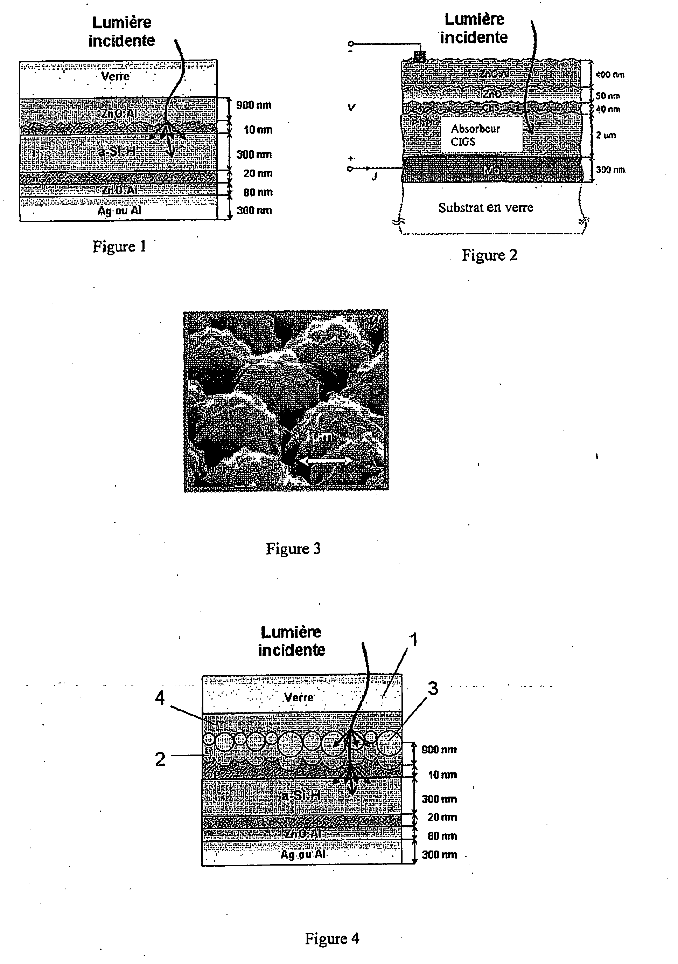

La figure 1 représente schématiquement une cellule solaire a-Si:H en configuration superstrat c'est-à-dire dans lesquelles la lumière entre à travers le substrat de verre et la figure 2 représente schématiquement la structure d'une cellule CIGS en configuration substrat.

Comme on le voit, dans ces structures, l'épaisseur typique de la couche de TCO varie de 200 nm à 1 µm.

Dans ces configurations, la couche de TCO, dont la fonction est de transmettre la lumière, sert à la fois d'électrode collectrice de charges et permet une diffusion de la lumière via sa « texturation ».

Actuellement, la référence dans le domaine des cellules solaires a-Si:H est le verre Asahi^{®} glass-U constitué d'un substrat de verre revêtu d'une couche de SnO₂:F déposée par APCVD.

La couche de TCO texturée est élaborée par, dépôt chimique en phase vapeur à pression atmosphérique (APCVD) à une température comprise entre 200 et 600°C pour obtenir la « texturation ».

En général, le TCO est de l'oxyde d'étain dopé au fluor (SnO₂:F).

Ainsi, ce verre est fabriqué selon un procédé décrit dans la Demande de Brevet européen n° 1 443 527 A1.

Ce procédé consiste à déposer sur un substrat en verre un film d'oxyde transparent conducteur, par dépôt chimique en phase vapeur à pression atmosphérique, à une température de 500°C en utilisant l'injection simultanée de tétrachlorure d'étain, d'eau et de chlorure d'hydrogène gazeux. Par ce procédé, des reliefs discontinus sont formés sur la surface du substrat de verre.

Ensuite, une couche continue d'oxyde transparent conducteur est formée sur ces reliefs discontinus par une méthode de dépôt chimique en phase vapeur à pression atmosphérique. Elle peut également être réalisée par un dépôt en phase vapeur à faisceaux d'électrons, une méthode de dépôt en phase vapeur sous vide, une méthode de pulvérisation ou une méthode de pulvérisation cathodique.

Dans le cas de l'APCVD, on obtient alors une « texturation » de la surface des creux et des reliefs formés lors du dépôt de la première couche d'oxyde, comme on le voit en figure 3 qui est une photographie prise au microscope électronique à balayage de la surface du verre Asahi^{®} glass-HU.

Cependant, dans ce procédé, les creux et reliefs formés, indépendamment de leur texturation, ont tous la même dimension et les verres obtenus présentent une transmission diffuse de la lumière supérieure à 80% seulement dans la zone des longueurs d'onde centrées autour de 350 à 400 nm.

De plus, ces valeurs de transmission diffuse diminuent très rapidement en dessous de 80% dès 550 nm.

Par ailleurs, J. Zhu et al. ont décrit, dans « Nanodome Solar Cells with Efficient Light Management and Self-Cleaning », Nanoletters 2009, une technique de structuration d'un empilement complet de cellules solaires a-Si:H par texturation en nanodomes du substrat. Ces nanodomes sont réalisés par gravure plasma de billes de silice préalablement déposées sur le substrat.

La gravure de ces billes permet d'obtenir un réseau périodique de nanodomes. Ce réseau périodique est ensuite répliquée dans toute la cellule via un dépôt multicouches.Cependant, ce procédé comporte de nombreuses étapes dont une étape de gravure des billes de silice. Or l'introduction d'étapes supplémentaires dans le procédé de fabrication entraine des coûts non négligeables.

Le document WO2006046397 divulgue la disposition de deux populations de billes sphériques de matériaux et de diamètres différents sous la couche d'oxyde conducteur.

L'invention vise à pallier les problèmes des procédés de formation de substrat comprenant une ou des couches diffusantes en oxyde transparent conducteur en proposant un substrat comprenant au moins une couche diffusante d'oxyde transparent conducteur, et un procédé pour sa fabrication, qui permet d'obtenir un facteur de diffusion ou Haze Value supérieure à 80% sur l'ensemble des longueurs d'onde comprises entre 350 et 1500 nm inclus, le procédé ne nécessitant que peu d'étapes de fabrication.

A cet effet, l'invention propose un substrat comprenant au moins une première couche diffusante en un oxyde transparent conducteur (TCO) déposée sur au moins une surface d'un support caractérisé en ce qu'il comprend de plus une couche de particules sphériques, en un matériau choisi parmi les matériaux diélectriques et les oxydes transparents conducteurs et dont les diamètres appartiennent à au moins deux populations de diamètre différents, sous la couche en TCO, la couche en TCO ayant une épaisseur sensiblement constante, c'est-à-dire étant un dépôt conforme.

Par épaisseur sensiblement constante, on entend qu'elle ne diffère pas de plus de 20 %, de préférence 10% en plus ou moins autour de la valeur moyenne d'épaisseur de la couche.

Par deux populations de diamètres différents, on entend en particulier, qu'au sein de la population totale de particules sphériques formant la couche 3, au moins 5%, en nombre, desdites particules ont un diamètre supérieur ou inférieur de plus de 500 mn, au diamètre d'au moins 5%, en nombre, de particules sphériques par rapport au nombre total de particules sphériques.

De préférence, le substrat de l'invention comprend de plus, entre le support et la couche de particules sphériques, une seconde couche en un oxyde transparent conducteur identique à, ou différent de, celui composant la première couche en TCO.

Avantageusement, les première et seconde couches en TCO enrobent la couche de particules sphériques, de manière que lesdites particules soient en contact continu avec les couches en TCO.

Le support du substrat de l'invention est en un matériau choisi parmi le verre, le silicium dopé p, le silicium dopé n, le silicium amorphe hydrogéné (a:SiH), du Cu(InGa)Se₂, du silicium mono- ou polycristallin, du CdS, ou une couche d'une cellule organique.

Au sein de la couche de particules sphériques mise en oeuvre dans l'invention, les particules ne sont pas en contact les unes avec les autres systématiquement. De préférence, elles ne sont que partiellement en contact.

Les particules sphériques ont, de préférence, un diamètre moyen compris entre 300 nm et 10 µm inclus. Ce diamètre peut être mesuré par microscope électronique à transmission.

Selon un mode de réalisation préféré, au sein de la population totale de particules sphériques formant la couche 3, il existe au moins 15%, en nombre, desdites particules dont le diamètre est supérieur ou inférieur de plus de 500 nm au diamètre d'au moins 15% en nombre des 100 % en nombre des particules sphériques.

Dans un autre mode de réalisation préféré, la population entière des particules sphériques comprend à la fois au moins 10%, de préférence 15%, en nombre, de particules d'un diamètre compris entre 200 nm et 4 µm inclus et au moins 10%, de préférence 15%, en nombre, de particules d'un diamètre compris entre 4,5 µm et 12 µm, inclus, le reste des particules ayant des diamètres intermédiaires.

Dans ce cas, plus préférablement, parmi la population dont le diamètre est compris entre 200 nm et 4 µm inclus, au moins 5%, en nombre, des particules, par rapport au nombre total de particules, ont un diamètre compris entre 300 nm et 3,5 µm, inclus, et parmi la population ayant un diamètre compris entre 4,5 µm et 12 µm, inclus, 5%, en nombre, par rapport au nombre total de particules, toutes populations confondues, ont un diamètre supérieur à 4,5 µm et inférieur à 6 µm.

Les particules sphériques sont en un matériau choisi parmi SiO₂, SnO₂, ZnO, ZnO, dopé Al, ZnO dopé B, SnO₂ dopé F, (ITO), oxyde d'indium dopé au fluor, In₂O₃Mo (IMO), ZnO dopé Ga.

Quant à l'oxyde transparent conducteur, il est choisi parmi ZnO:A1 (AZO), ZnO:B (BZO), ZnO:Ga (GZO), SnO₂:F, In₂O₃:Sn (ITO), ITO:ZnO, ITO:Ti, In₂O₃, In₂O₃-ZnO (IZO), In₂O₃:F, In₂O₃:Mo (IMO), In₂O₃:Ga, In₂O₃:Ti, In₂O₃:W, In₂O₃:Zr, In₂O₃:Nb, ZnO(Al,F), ZnO:(Ga,B).

L'invention propose également un procédé de fabrication d'un substrat comprenant au moins une couche diffusante en un oxyde transparent conducteur (TCO) caractérisé en qu'il comprend les étapes suivantes :
a) dépôt sur au moins une surface d'un support d'une couche de particules sphériques, en un matériau choisi parmi les matériaux diélectriques et les oxydes transparents conducteurs dont les diamètres appartiennent à au moins deux populations différentes de diamètre, et
b) dépôt sur la surface libre de la couche de particules sphériques d'une couche en un oxyde transparent conducteur conforme.

Dans un mode de réalisation préféré, le procédé de l'invention comprend de plus, avant l'étape a), une étape de dépôt d'une seconde couche en oxyde transparent conducteur identique à, ou différent de, celui composant la première couche en TCO à déposer sur la couche de particules sphériques, sur le support, cette couche ayant à sa surface en contact avec la couche, 1a forme de la surface formée par la couche avec laquelle elle est en contact.

Selon une première variante, le(s) dépôt(s) de la (des) couche(s) en oxyde transparent conducteur est (sont) effectué(s) par dépôt physique en phase vapeur (PVD).

De préférence, et selon une seconde variante, le(s) dépôt(s) de 1a (des) couche(s) en oxyde transparent conducteur est (sont) effectué(s) par dépôt chimique en phase vapeur (CVD).

Dans toutes les variantes du procédé de l'invention, le support est en un matériau choisi parmi le verre, le silicium dopé p, le silicium dopé n, le silicium amorphe hydrogéné (a:SiH), du Cu(InGa)Se₂, du silicium mono ou polycristallin, du CdS, et une couche d'une cellule organique.

Egalement préférablement, les particules sphériques ont un diamètre compris entre 300 nm et 10 µm inclus.

Le plus préférablement, la population totale des particules sphériques comprend à la fois au moins 10%, de préférence 15%, en nombre, de particules d'un diamètre compris entre 200 nm et 4 µm inclus, et au moins 10%, de préférence 15%, en nombre, de particules d'un diamètre compris entre 4,5 µm et 12 µm, inclus, le reste étant constitué de particules de diamètres intermédiaires.

De plus, de préférence, les particules sphériques sont en un matériau choisi parmi SiO₂, ZnO, SiO₂, ZnO, ZnO dopé Al, ZnO dopé B, SnO₂ dopé F (ITO), oxyde d'indium dopé au fluor, et In₂O₃Mo (IMO) et ZnO dopé Ga.

Quant à l'oxyde transparent conducteur, il est, de préférence, choisi parmi ZnO:Al (AZO), ZnO:B (BZO), ZnO:Ga (GZO), SnO₂:F, In₂O₃:Sn (ITO), ITO:ZnO, ITO:Ti, In₂O₃, In₂O₃-ZnO (IZO), In₂O₃:F, In₂O₃:Mo (IMO), In₂O₃:Ga, In₂O₃:Ti, In₂O₃:W, In₂O₃:Zr, In₂O₃:Nb, ZnO(Al,F), ZnO:(Ga,B).

L'invention propose aussi une cellule solaire comprenant un substrat selon l'invention ou obtenue par le procédé selon l'invention.

L'invention sera mieux comprise et d'autres caractéristiques et avantages de celle-ci apparaitront plus clairement à la lecture de la description explicative qui suit et qui est faite en référence aux figures annexées dans lesquelles :
- 1a figure 1 représente la configuration d'une cellule solaire a-Si:H de l'art antérieur, en configuration superstrat,
- la figure 2 représente schématiquement la structure d'une cellule solaire CIGS de l'art antérieur, en configuration substrat,
- la figure 3 est une photographie par microscopie électronique à balayage de la surface de la couche d'oxyde transparent conducteur obtenue par le procédé décrit dans la Demande de Brevet Européen n°1 443 527 A et vendue sous la marque Asahi^{®} HU,

- 1a figure 4 représente schématiquement la structure d'une cellule solaire a-Si:H en configuration superstrat, selon l'invention,

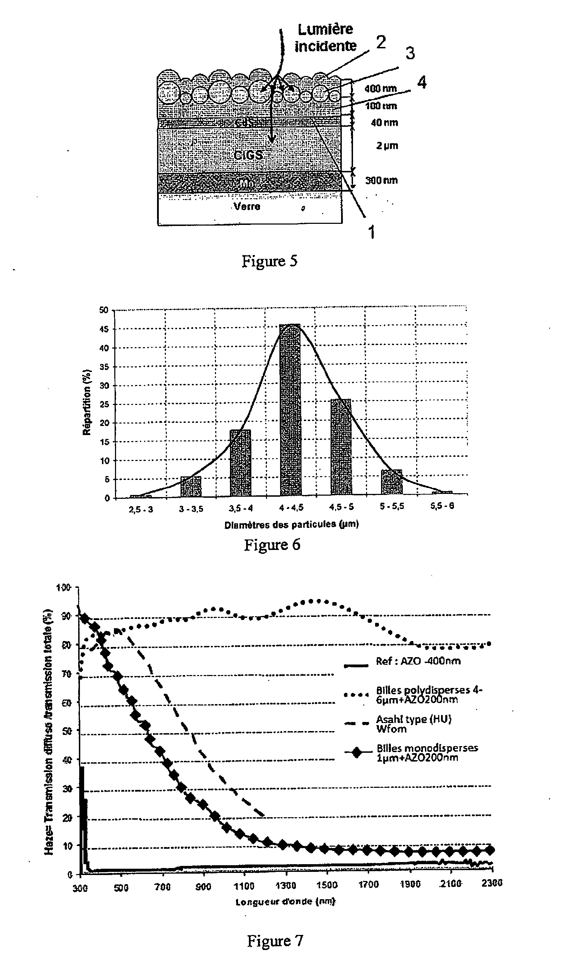

- la figure 5 représente schématiquement la structure d'une cellule solaire CIGS en configuration substrat, selon l'invention,
- la figure 6 représente la répartition granulométrique des billes de silice utilisées à l'exemple 1, et
- la figure 7 représente le facteur de diffusion de la lumière, en fonction de la longueur d'onde incidente, obtenu :
- avec un substrat selon l'invention avec soit des billes monodisperses, soit des billes polydisperses,
- le substrat Asahi^{®} type HU, et
- un substrat comprenant une couche en oxyde transparent conducteur sans texturation.

La réponse optique d'une couche d'oxyde transparent conducteur texturé est en générale traduite par la Haze Value c'est-à-dire le facteur de diffusion de la lumière.

Cette grandeur représente le rapport de la lumière diffusée transmise sur la lumière totale transmise.

Il a été largement démontré que cette grandeur est améliorée lorsque la couche en oxyde transparent conducteur (TCO) est texturée.

Dans ce qui suit, le terme « texturation » désigne la rugosité créée, c'est-à-dire la succession de creux et reliefs formées sur ou par la couche de TCO.

Comme on le voit en figures 4 et 5, le substrat selon l'invention comprend au moins une couche diffusante en un oxyde transparent conducteur, notée 2 en figures 4 et 5, sur un support, noté 1 en figures 4 et 5, comme dans les substrats déposés de l'art antérieur montrés en figures 1, 2 et 3. Mais à la différence des substrats de l'art antérieur représentés en figures 1, 2 et 3, le substrat de l'invention comprend de plus une couche, notée 3 aux figures 4 et 5, de particules sphériques en un matériau choisi parmi les matériaux diélectriques et les oxydes transparents conducteurs.

A cet effet, des particules sphériques en matériau tel que, par exemple SiO₂, ZnO, l'oxyde d'étain dopé indium, sont déposées entre le support 1 et la couche 2. La taille de ces particules sphériques appartient à au moins deux populations de diamètres.

Autrement dit, les particules sphériques constituant la couche 3 n'ont pas toutes le même diamètre.

Grâce à la taille variable de ces particules, une efficacité optimale de la quantité de lumière transmise diffuse est obtenue sur une large gamme de longueurs d'onde c'est-à-dire de 350 nm à 1500 nm.

La taille de ces particules varie entre 300 nm et 10 µm. On obtint ainsi des reliefs et des creux de hauteurs et largeurs diliférentes, ce qui n'était pas possible par le procédé de la Demande de Brevet Européen 1 443 527 A1. On pourra, bien entendu, sélectionner des tailles (diamètre) de particules diélectriques, de façon à sélectionner un intervalle précis de longueurs d'onde.

Dans un mode de réalisation préféré, et pour obtenir l'efficacité optimale sur un large intervalle de longueurs d'onde compris entre 350 nm et 1500 nm, on utilisera une population totale des particules sphériques comprenant à la fois au moins 10%, de préférence 15%, en nombre, de particules d'un diamètre compris entre 200 nm et 4 µm inclus, et au moins 10%, de préférence 15%, en nombre, de particules d'un diamètre compris entre 4,5 µm et 12 µm, inclus, le reste étant constitué de particules de diamètres intermédiaires.

Selon un perfectionnement de l'invention, parmi les 15% suscités, au moins 5%, en nombre, (par rapport à la population totale) ont un diamètre compris entre 300 nm et 3,5 µm, inclus, et 5%, en nombre, (par rapport à la population totale) ont un diamètre compris entre 4,5 µm et µm, inclus.

Afin d'obtenir encore une meilleure efficacité de transmission diffuse et dans une mode de réalisation particulièrement préféré, les particules sphériques ne sont pas toutes en contact les unes avec les autres, et de préférence, sont toutes séparées les unes des autres.

Ceci signifie, comme on le voit en figures 4 et 5, que ces particules sphériques forment une monocouche, c'est-à-dire qu'il n'y a pas empilement de particules sphériques l'une sur l'autre.

Le dépôt des particules sphériques est de préférence réalisé par la technique de dépôt du type Langmuir-Blodgett qui a l'avantage d'être peu onéreuse pour le traitement de grandes surfaces, ou encore par des dépôts à la tournette (Spin-Coating) ou par trempage (Deep-Coating) d'un Sol-Gel en contrôlant précisément la taille et la densité surfacique des particules sphériques. On utilise de préférence des nano-composites polymère liquide / particules sphériques dont la concentration en particules détermine la densité finale sur la surface du substrat traité. Le solvant polymère est ensuite évaporé par traitement thermique. L'utilisation d'un tensio-actif peut être envisagée pour favoriser une bonne dispersion des particules.

Cette couche 3 de particules sphériques, est ensuite revêtue de la couche en oxyde transparent conducteur.

Comme on le voit sur les figures 4 et 5, la couche 2 en oxyde conducteur transparent a la forme, en négatif de la surface de la couche 3 de particules sphériques. Elle a la même épaisseur en tous points. C'est un dépôt conforme.

A titre d'oxyde conducteur transparent, on peut utiliser tout oxyde conducteur transparent connu de l'homme de l'art. A titre d'exemple, on citera ZnO dopé Al, l'oxyde d'étain dopé indium (ITO), l'oxyde d'étain dopé au molybdène (IMO), SnO₂ non dopé ou dopé au fluor (SnO₂:F), SnO₂, ZnO dopé B, SnO₂ dopé F, (ITO), oxyde d'indium dopé au fluor, In₂O₃Mo (IMO), ZnO dopé Ga.

Dans une variante préférée de l'invention, le dispositif de l'invention comprend de plus, entre le substrat 1 et la couche 3 de particules sphériques, une seconde couche, notée 4 en figures 4 et 5, en un oxyde transparent conducteur identique à celui de la couche 2 ou différent de celui-ci.

L'oxyde transparent conducteur de la couche 4 est choisi parmi les mêmes matériaux que ceux cités pour la couche 2.

Le dépôt d'oxyde transparent conducteur pour former la couche 2 ou la couche 4 peut être réalisé par dépôt physique en phase vapeur (PVD) ou par dépôt chimique en phase vapeur (CVD).

Ces techniques permettent d'inclure les particules sphériques en un matériau diélectrique dans une couche mince de TCO. Les particules sphériques sont enrobées.

Lorsque le dépôt est effectué par PVD, la surface des creux et reliefs formant la couche 2 et/ou 4 TCO ne présente pas de « texturation », c'est-à-dire est parfaitement lisse.

Cependant, pour obtenir une couche 2 en TCO épousant parfaitement la forme des particules sphériques, à la surface qu'elles forment, et ayant en tous points la même épaisseur, il est préférable d'utiliser la méthode CVD. Dans ce cas, la surface des creux et reliefs épousant la forme de la couche 3 de particules sphériques présenteront eux-mêmes une rugosité (texturation).

Le procédé de fabrication du substrat de l'invention comprend les étapes suivantes :
a) dépôt sur au moins une surface du support 1 d'une couche 3 de particules sphériques en un matériau choisi parmi les matériaux diélectriques et les oxydes transparents conducteurs, dont les diamètres appartiennent à au moins deux populations différentes de diamètre, et
b) dépôt sur la surface libre de la couche 3 d'une couche en un oxyde transparent conducteur.

Dans un mode de réalisation préféré, le procédé de l'invention comprend de plus, avant l'étape a), une étape de dépôt de la couche 4 en oxyde transparent conducteur identique à, ou différent de, celui composant la couche 2.

Les méthodes de dépôt des couches 2 et/ou 4 et des particules sphériques ont déjà été décrites ci-dessus et la nature des matériaux constituant ces couches 2 et/ou 4 et 3 a également déjà été décrite ci-dessus.

La taille des particules sphériques a aussi été décrite ci-dessus.

Le substrat de l'invention ou obtenu par le procédé de l'invention est particulièrement approprié pour former une couche diffusante en TCO pour cellule solaire.

Dès lors, un objet de l'invention est également une cellule solaire comprenant un tel substrat.

Afin de mieux faire comprendre l'invention, on va maintenant décrire à titre d'exemples purement illustratifs et non limitatifs des exemples de mise en oeuvre.

### Exemple 1 :

Formation d'une couche diffusante en TCO à base de particules sphériques de silice : formation d'un substrat selon l'invention.

Dans une première étape, on dépose, sur un support en verre, une couche de ZnO dopée à 2,5% en masse en aluminium d'une épaisseur de 100 nm par pulvérisation cathodique magnétron.

Puis on dépose des particules sphériques de silice, dont la répartition granulométrique est représentée en figure 6, par un procédé de type Langmuir-Blodgett.

On recouvre ensuite la couche de particules sphériques d'une couche de ZnO dopée à 2,5% en Al par dépôt pulvérisation cathodique magnétron. Cette couche a une épaisseur de 400 nm.

### Exemple 2 :

Dans cet exemple, la première couche de ZnO dopée à 2,5% d'Al est déposée par une technique de pulvérisation magnétron.

Les paramètres utilisés lors du dépôt sont présentés ci-après

| | |
|---|---|
| **Cible** | **ZnO : Al (2,5%wt)** |
| **Diamètre cible** | **200mm** |
| **Substrat** | **Verre Eagle XG** |
| **Pression** | **0,15 Pa** |
| **Débit Ar** | **20sccm** |
| **Mouvement** | **Rotation - 10tr/mn** |
| **Puissance** | **500W** |
| **Densité de puissance** | **1,6W/cm²** |
| **Distance cible substrat** | **55mm** |
| **Temps** | **38mn** |
| **Vitesse dépôt** | **100nm/mn** |

Puis on procède au dépôt de particules de silice monodisperses de diamètre 1 µm.

Le dépôt de ces particules est effectué par une technique de type Langmuir-Blodgett.

Puis une seconde couche de ZnO dopé à 2,5% d'Al d'une épaisseur de 200 nm est déposée sur la monocouche de particules de silice de manière à la suivre intégralement.

Ce dépôt est effectué par pulvérisation magnétron. Les paramètres utilisés lors de ce dépôt sont identiques à ceux utilisés à l'exemple 1.

### Résultats :

On a ensuite mesuré, par spectrophotométrie, le facteur de diffusion de la lumière incidente à travers le substrat obtenu à l'exemple 1 et pour comparaison le facteur de diffusion de la lumière obtenue avec la structure de type HU de Asahi^{®} et avec une structure comprenant uniquement une couche en ZnO dopé à 2,5% d'aluminium déposée directement sur le substrat en verre, sans « texturation » et avec une structure selon l'invention mais pour laquelle les particules sphériques sont monodisperses, telle qu'obtenue à l'exemple 2.

Les courbes obtenues sont représentées en figure 7.

Comme on le voit en figure 7, la structure constituée uniquement de la couche de ZnO dopée à 2,5% d'Al sur le verre ne présente pas de facteur de diffusion. Il s'agit ici de la référence.

Quant à la structure de type HU de Asahi^{®}, on constate qu'elle présente un facteur de diffusion supérieur à 80% uniquement dans la gamme des longueurs d'onde comprise entre 350 et 550 nm avec un maximum à 500 nm.

De façon équivalente, l'utilisation de sphères monodisperses n'améliorent pas le facteur de diffusion.

En contraste, avec le substrat selon l'invention, le facteur de diffusion est supérieur à 80% dans un large intervalle de longueurs d'onde comprises entre 310 et 2300 nm.

## Revendications

1. Substrat comprenant au moins une couche (2) diffusante en un oxyde transparent conducteur (TCO) déposée sur au moins une surface d'un support (1) **caractérisé en ce qu'**il comprend de plus une couche (3) de particules sphériques, de préférence ayant un diamètre compris entre 300 nm et 10 µm inclus, en un matériau choisi parmi les matériaux diélectriques et les oxydes transparents conducteurs, et dont les diamètres appartiennent à au moins deux populations de diamètre différents, sous la couche (2) en TCO, la couche (2) en TCO ayant une épaisseur sensiblement constante.

2. Substrat selon la revendication 1 **caractérisé en ce qu'**il comprend de plus, entre le support (1) et la couche (3) de particules sphériques, une seconde couche (4) en un oxyde transparent conducteur identique à, ou différent de, celui composant la couche (2).

3. Substrat selon la revendication 2 **caractérisé en ce que** les première et seconde couches (2, 4) en TCO enrobent la couche (3) de particules sphériques.

4. Substrat selon l'une quelconque des revendications précédentes **caractérisé en ce que** le support (1) est en un matériau choisi parmi le verre, le silicium dopé p, le silicium dopé n, le silicium amorphe hydrogéné (a:SiH), du Cu(InGa)Se₂), du silicium mono- ou polycristallin, du CdS, ou d'une couche d'une cellule organique.

5. Substrat selon l'une quelconque des revendications précédentes **caractérisé en ce qu'**au sein de la population totale de particules sphériques formant la couche (3), au moins 5%, en nombre, desdites particules ont un diamètre supérieur ou inférieur de plus de 500 nm, au diamètre d'au moins 5%, en nombre, de particules sphériques par rapport au nombre total de particules sphériques.

6. Substrat selon l'une quelconque des revendications précédentes **caractérisé en ce que** les particules sphériques sont en un matériau choisi parmi SiO₂, ZnO, ZnO dopé Al, ZnO dopé B, SnO₂ dopé F (ITO), oxyde d'indium dopé au fluor, et In₂O₃Mo (IMO) et ZnO dopé Ga.

7. Substrat selon l'une quelconque des revendications précédentes **caractérisé en ce que** l'oxyde transparent conducteur est choisi ZnO:Al (AZO), ZnO:B (BZO), ZnO:Ga (GZO), SnO₂:F, In₂O₃:Sn(ITO), ITO:ZnO, ITO:Ti, In₂O₃, In₂O₃-ZnO (IZO), In₂O₃:F, In₂O₃:Mo (IMO), In₂O₃:Ga, In₂O₃:Ti, In₂O₃:W, In₂O₃:Zr, In₂O₃:Nb, ZnO(Al,F), ZnO:(Ga,B).

8. Procédé de fabrication d'un substrat comprenant au moins une couche (2) diffusante en un oxyde transparent conducteur (TCO) caractérisé en qu'il comprend les étapes suivantes :
a) dépôt sur au moins une surface d'un support (1), de préférence en un matériau choisi parmi le verre, le silicium dopé p, le silicium dopé n, le silicium amorphe hydrogéné (a:SiH), du Cu(InGa)Se₂), du silicium mono- ou polycristallin, du CdS, ou d'une couche d'une cellule organique, d'une couche (3) de particules sphériques en un matériau choisi parmi les matériaux diélectriques et les oxydes transparents conducteurs, de préférence en un matériau choisi parmi SiO₂, ZnO, ZnO dopé Al, ZnO dopé B, SnO₂ dopé F (ITO), oxyde d'indium dopé au fluor, et In₂O₃Mo (IMO) et ZnO dopé Ga, et dont les diamètres appartiennent à au moins deux populations différentes de diamètre, et
b) dépôt sur la surface libre de la couche (3) d'une couche (2) en un oxyde transparent conducteur ayant une épaisseur sensiblement constante.

9. Procédé selon la revendication 8 **caractérisé en ce qu'**il comprend de plus ; avant l'étape a), une étape de dépôt d'une couche (4) en oxyde transparent conducteur identique à, ou différent de, celui composant la première couche (2), entre le substrat (1) et la couche (3), de particules sphériques en un matériau diélectrique, la couche (4) ayant à sa surface en contact avec la couche (3), la forme de la surface formée par la couche (3) avec laquelle elle est en contact.

10. Procédé selon la revendication 8 ou 9 **caractérisé en ce que** le(s) dépôt(s) de la (des) couche(s) en oxyde transparent conducteur est (sont) effectué(s) par dépôt physique en phase vapeur (PVD).

11. Procédé selon la revendication 8 ou 9 **caractérisé en ce que** le(s) dépôt(s) de la (des) couche(s) en oxyde transparent conducteur est (sont) effectué(s) par dépôt chimique en phase vapeur (CVD).

12. Procédé selon l'une quelconque des revendications 8 à 11 **caractérisé en ce que** les particules sphériques ont un diamètre compris entre 300 nm et 10 µm inclus.

13. Procédé selon l'une quelconque des revendications 8 à 12 **caractérisé en ce que** la population totale des particules sphériques comprend à la fois au moins 10%, de préférence 15%, en nombre, de particules d'un diamètre compris entre 200 nm et 4 µm inclus, et au moins 10%, de préférence 15%, en nombre, de particules d'un diamètre compris entre 4,5 µm et 12 µm, inclus, le reste étant constitué de particules de diamètres intermédiaires.

14. Procédé selon l'une quelconque des revendications 8 à 13 **caractérisé en ce que** l'oxyde transparent conducteur est choisi parmi ZnO:Al (AZO), ZnO:B (BZO), ZnO:Ga (GZO), SnO₂:F, In₂O₃:Sn (ITO), ITO:ZnO, ITO:Ti, In₂O₃, In₂O₃-ZnO (IZO), In₂O₃:F, In₂O₃:MO (IMO), In₂O₃:Ga, In₂O₃:Ti, In₂O₃:W, In₂O₃:Zr, In₂O₃:Nb, ZnO(Al,F), ZnO:(Ga,B).

15. Cellule solaire **caractérisée en ce qu'**elle comprend un substrat selon l'une quelconque des revendications 1 à 7 ou obtenue par le procédé selon l'une quelconque des revendications 8 à 14.

## Patentansprüche

1. Substrat, umfassend wenigstens eine Diffusionsschicht (2) aus einem transparenten, elektrisch leitfähigen Oxid (TCO), die auf wenigstens einer Oberfläche eines Trägers (1) abgeschieden ist, **dadurch gekennzeichnet, dass** es unter der Schicht (2) aus TCO weiterhin eine Schicht (3) aus sphärischen Partikeln umfasst, die vorzugsweise einen Durchmesser zwischen einschließlich 300 nm und 10 µm haben und aus einem Material sind, das ausgewählt ist aus dielektrischen Materialien und transparenten, elektrisch leitfähigen Oxiden, und deren Durchmesser zu wenigstens zwei verschiedenen Durchmesserpopulationen gehören, wobei die Schicht (2) aus TCO eine im Wesentlichen konstante Dicke aufweist.

2. Substrat nach Anspruch 1, **dadurch gekennzeichnet, dass** es weiterhin zwischen dem Träger (1) und der Schicht (3) aus sphärischen Partikeln eine zweite Schicht (4) aus einem transparenten, elektrisch leitfähigen Oxid umfasst, das mit demjenigen, das die Schicht (2) bildet, identisch oder von diesem verschieden ist.

3. Substrat nach Anspruch 2, **dadurch gekennzeichnet, dass** die erste und zweite Schicht (2, 4) aus TCO die Schicht (3) aus sphärischen Partikeln ummanteln.

4. Substrat nach einem der vorhergehenden Ansprüche, **dadurch gekennzeichnet, dass** der Träger (1) aus einem Material ist, das ausgewählt ist aus Glas, p-datiertem Silicium, n-dotiertem Silicium, amorphem hydrierten Silicium (a:SiH), Cu(InGa)Se₂, mono- oder polykristallinem Silicium, CdS oder einer Schicht aus einer organischen Zelle.

5. Substrat nach einem der vorhergehenden Ansprüche, **dadurch gekennzeichnet, dass** innerhalb der Gesamtpopulation der sphärischen Partikel, die die Schicht (3) bilden, wenigstens 5% der Anzahl dieser Partikel einen Durchmesser von mehr als 500 nm über oder unter dem Durchmesser von wenigstens 5% der Anzahl von sphärischen Partikeln haben, bezogen auf die Gesamtzahl sphärischer Partikel.

6. Substrat nach einem der vorhergehenden Ansprüche, **dadurch gekennzeichnet, dass** die sphärischen Partikel aus einem Material sind, das ausgewählt ist aus SiO₂, ZnO, Al-dotiertem ZnO, B-dotiertem ZnO, F-dotiertem SnO₂ (ITO), Fluor-dotiertem Indiumoxid und In₂O₃Mo (IMO) und Ga-dotiertem ZnO.

7. Substrat nach einem der vorhergehenden Ansprüche, **dadurch gekennzeichnet, dass** das transparente, elektrisch leitfähige Oxid ausgewählt ist aus ZnO:Al (AZO), ZnO:B (BZO), ZnO:Ga (GZO), SnO₂:F, In₂O₃:Sn (ITO), ITO:Zn, ITO:Ti, In₂O₃, In₂O₃-ZnO (IZO), In₂O₃:F, In₂O₃Mo (IMO), In₂O₃:Ga, In₂O₃:Ti, In₂O₃:W, In₂O₃,Zr, In₂O₃:Nb, ZnO(Al,F), ZnO:(Ga,B).

8. Verfahren zur Herstellung eines Substrats, das wenigstens eine Diffusionsschicht (2) aus einem transparenten, elektrisch leitfähigen Oxid (TCO) umfasst, **dadurch gekennzeichnet, dass** es die folgenden Schritte umfasst:
(a) Abscheiden auf wenigstens einer Oberfläche eines Trägers (1), vorzugsweise aus einem Material, das ausgewählt ist aus Glas, p-dotiertem Silicium, n-dotiertem Silicium, amorphem hydrierten Silicium (a:SiH), Cu(InGa)Se₂, mono- oder polykristallinem Silicium, CdS oder einer Schicht aus einer organischen Zelle, einer Schicht (3) aus sphärischen Partikeln aus einem Material, das ausgewählt ist aus dielektrischen Materialien und transparenten, elektrisch leitfähigen Oxiden, vorzugsweise aus einem Material, das ausgewählt ist aus SiO₂, ZnO, Al-dotiertem ZnO, B-dotiertem ZnO, F-dotiertem SnO₂ (ITO), Fluor-dotiertem Indiumoxid und In₂O₃Mo (IMO) und Ga-dotiertem ZnO, und deren Durchmesser zu wenigstens zwei verschiedenen Durchmesserpopulationen gehören, und
(b) Abscheiden auf der freien Oberfläche der Schicht (3) einer Schicht (2) aus einem transparenten, elektrisch leitfähigen Oxid, die eine im Wesentlichen konstante Dicke aufweist.

9. Verfahren nach Anspruch 8, **dadurch gekennzeichnet, dass** es weiterhin vor Schritt (a) umfasst: einen Schritte des Abscheidens einer Schicht (4) aus transparentem, elektrisch leitfähigen Oxid, das mit dem, das die erste Schicht (2) bildet, identisch oder von diesem verschieden ist, zwischen dem Träger (1) und der Schicht (3) aus sphärischen Partikeln aus einem dielektrischen Material, wobei die Oberfläche von Schicht (4), die in Kontakt mit der Schicht (3) ist, die Form der von Schicht (3) gebildeten Oberfläche aufweist, mit der sie in Kontakt ist.

10. Verfahren nach Anspruch 8 oder 9, **dadurch gekennzeichnet, dass** das Abscheiden der Schicht(en) aus transparentem, elektrisch leitfähigem Oxid durch physikalische Gasphasenabscheidung (PVD) erfolgt.

11. Verfahren nach Anspruch 8 oder 9, dadurch gekenntzeichnet, dass das Abscheiden der Schicht(en) aus transparentem, elektrisch leitfähigem Oxid durch chemische Gasphasenabscheidung (CVD) erfolgt.

12. Verfahren nach einem der Ansprüche 8 bis 11, **dadurch gekennzeichnet, dass** die sphärischen Partikel einen Durchmesser zwischen einschließlich 300 nm und 10 µm haben.

13. Verfahren nach einem der Ansprüche 8 bis 12, **dadurch gekennzeichnet, dass** die Gesamtpopulation der sphärischen Partikel anzahlmäßig zusammengenommen wenigstens 10%, vorzugsweise 15% Partikel mit einem Durchmesser zwischen einschließlich 200 nm und 4 µm und anzahlmäßig wenigstens 10%, vorzugsweise 15% Partikel mit einem Durchmesser zwischen einschließlich 4,5 µm und 12 µm umfasst, wobei der Rest aus Partikeln mit einem Durchmesser dazwischen besteht.

14. Verfahren nach einem der Ansprüche 8 bis 13, **dadurch gekennzeichnet, dass** das transparente, elektrisch leitfähige Oxid ausgewählt ist aus ZnO:Al (AZO), ZnO:B (BZO), ZnO:Ga (GZO), SnO₂:F, In₂O₃:Sn (ITO), ITO:Zn, ITO:Ti, In₂O₃, In₂O₃-ZnO (IZO), In₂O₃:F, In₂O₃:Mo (IMO), In₂O₃:Ga, In₂O₃:Ti, In₂O₃:W, In₂O₃:Zr, In₂O₃:Nb, ZnO(Al,F), ZnO:(Ga,B).

15. Solarzelle, dadurch gekenntzeichnet, dass sie ein Substrat nach einem der Ansprüche 1 bis 7 oder ein nach dem Verfahren gemäß einem der Ansprüche 8 bis 14 erhaltenes Substrat umfasst.

## Claims

1. Substrate comprising at least one diffusing layer (2) made of a transparent conductive oxide (TCO) which is deposited on at least one surface of a support (1), **characterised in that** it further comprises a layer (3) of spherical particles which preferably have a diameter of between 300 nm and 10 µm inclusive, made of a material selected from dielectric materials and transparent conductive oxides and whose diameters belong to at least two populations of different diameters, under the layer (2) of TCO, the layer (2) of TCO having a substantially constant thickness.

2. Substrate according to claim 1, **characterised in that** it further comprises, between the support (1) and the layer (3) of spherical particles, a second layer (4) made of a transparent conductive oxide which is identical to or different from the one which forms the layer (2).

3. Substrate according to claim 2, **characterised in that** the first and second layers (2, 4) of TCO coat the layer (3) of spherical particles.

4. Substrate according to any one of the preceding claims, **characterised in that** the support (1) is made of a material selected from glass, p-doped silicon, n-doped silicon, hydrogenous amorphous silicon (a:SiH), Cu(InGa)Se₂, monocrystalline or polycrystalline silicon, CdS or a layer of an organic cell.

5. Substrate according to any one of the preceding claims, **characterised in that**, within the total population of spherical particles which form the layer (3), at least 5% by number of the particles have a diameter which is more than 500 nm greater than or less than the diameter of at least 5% by number of the spherical particles compared with the total number of spherical particles.

6. Substrate according to any one of the preceding claims, **characterised in that** the spherical particles are made of a material selected from SiO₂, ZnO, Al-doped ZnO, B-doped ZnO, F-doped SnO₂ (ITO), fluorine-doped indium oxide and In₂O₃Mo (IMO) and Ga-doped ZnO.

7. Substrate according to any one of the preceding claims, **characterised in that** the transparent conductive oxide is selected from ZnO:Al (AZO), ZnO:B (BZO), ZnO:Ga (GZO), SnO₂ : F, In₂O₃:Sn(ITO), ITO:ZnO, ITO:Ti, In₂O₃, In₂O₃ZnO (IZO), In₂O₃:F, In₂O₃:Mo (IMO), In₂O₃:Ga, In₂O₃:Ti, In₂O₃:W, In₂O₃:Zr, In₂O₃: Nb, ZnO(Al, F), ZnO: (Ga, B) .

8. Method for manufacturing a substrate comprising at least one diffusing layer (2) made of a transparent conductive oxide (TCO), **characterised in that** it comprises the following steps:
a) depositing on at least one surface of a support (1), preferably made of a material selected from glass, p-doped silicon, n-doped silicon, hydrogenous amorphous silicon (a:SiH), Cu(InGa)Se₂, monocrystalline or polycrystalline silicon, CdS or a layer of an organic cell, a layer (3) of spherical particles made of a material selected from dielectric materials and transparent conductive oxides, preferably of a material selected from SiO₂, ZnO, Al-doped ZnO, B-doped ZnO, F-doped SnO₂ (ITO), fluorine-doped indium oxide and In₂O₃M_{O} (IMO) and Ga-doped ZnO, and whose diameters belong to at least two populations which have different diameters, and
b) depositing on the free surface of the layer (3) a layer (2) made of a transparent conductive oxide having a substantially constant thickness.

9. Method according to claim 8, **characterised in that** it further comprises, before step a), a step of depositing a layer (4) made of a transparent conductive oxide which is identical to, or different from, the one which forms the first layer (2), between the substrate (1) and the layer (3), of spherical particles made of a dielectric material, the layer (4) having at the surface thereof in contact with the layer (3), the shape of the surface formed by the layer (3) with which it is in contact.

10. Method according to claim 8 or claim 9, **characterised in that** the deposit (s) of the layer(s) made of a transparent conductive oxide is(are) carried out by means of chemical vapour deposition (CVD).

11. Method according to claim 8 or claim 9, **characterised in that** the deposit(s) of the layer(s) made of a transparent conductive oxide is(are) carried out by means of chemical vapour deposition (CVD).

12. Method according to any one of claims 8 to 11, **characterised in that** the spherical particles have a diameter of between 300 nm and 10 µm inclusive.

13. Method according to any one of claims 8 to 12, **characterised in that** the total population of spherical particles comprises both at least 10%, preferably 15%, by number, of particles having a diameter of between 200 nm and 4 µm inclusive, and at least 10%, preferably 15%, by number, of particles having a diameter between 4.5 µm and 12 µm inclusive, the remainder being constituted by particles having intermediate diameters.

14. Method according to any one of claims 8 to 13, **characterised in that** the transparent conductive oxide is selected from ZnO:Al (AZO), ZnO:B(BZO), ZnO:Ga (GZO), SnO₂:F, In₂O₃:Sn(ITO), ITO:ZnO, ITO:Ti, In₂O₃, In₂O₃-ZnO (IZO), In₂O₃:F, In₂O₃:Mo (IMO), In₂O₃:Ga, In₂O₃:Ti, In₂O₃:W, In₂O₃:Zr, In₂O₃:Nb, ZnO(Al, F), ZnO:(Ga, B).

15. Solar cell **characterised in that** it comprises a substrate according to any one of claims 1 to 7 or obtained by the method according to any one of claims 8 to 14.
